# EUROPÄISCHE PATENTSCHRIFT

(11) **EP 1 612 937 B1**
(45) Veröffentlichungstag und Bekanntmachung des Hinweises auf die Patenterteilung: **21.11.2007**
(21) Anmeldenummer: 05007925.0
(22) Anmeldetag: 12.04.2005
(51) Int. Cl.: H03K 17/22, H03K 17/28, H03F 3/72

(54) **Verfahren zur Formung von Signalspektren**
Method of forming signal spectra
Méthode pour former des spectres de signaux

(30) Priorität: 30.06.2004 DE 102004031603
(43) Veröffentlichungstag der Anmeldung: 04.01.2006
(73) Patentinhaber: EADS Deutschland GmbH, 85521 Ottobrunn (DE)
(72) Erfinder: Lücke, Sven, 85716 Unterschleissheim (DE); Salomon, Andreas, 85716 Unterschleissheim (DE); Hoffmann, Gebhard, Dr., 80805 München (DE); Wedemeyer, Markus, 85764 Oberschleissheim (DE)
(74) Vertreter: Meel, Thomas

(56) Entgegenhaltungen:
- EP-A- 0 380 361
- PATENT ABSTRACTS OF JAPAN Bd. 009, Nr. 288 (E-358), 15. November 1985 (1985-11-15) -& JP 60 127806 A (TOSHIBA KK), 8. Juli 1985 (1985-07-08)
- PATENT ABSTRACTS OF JAPAN Bd. 014, Nr. 429 (E-0978), 14. September 1990 (1990-09-14) -& JP 02 166908 A (NEC CORP), 27. Juni 1990 (1990-06-27)
- PATENT ABSTRACTS OF JAPAN Bd. 006, Nr. 155 (E-125), 17. August 1982 (1982-08-17) & JP 57 076932 A (FUJITSU LTD), 14. Mai 1982 (1982-05-14)
- PATENT ABSTRACTS OF JAPAN Bd. 015, Nr. 022 (E-1024), 18. Januar 1991 (1991-01-18) & JP 02 268008 A (TOYO COMMUN EQUIP CO LTD), 1. November 1990 (1990-11-01)
- PATENT ABSTRACTS OF JAPAN Bd. 014, Nr. 394 (E-0969), 24. August 1990 (1990-08-24) & JP 02 146822 A (SEIKO INSTR INC), 6. Juni 1990 (1990-06-06)

## Beschreibung

Die Erfindung betrifft ein Verfahren zur Formung von Signalspektren gemäß dem Oberbegriff des Patentanspruchs 1 sowie eine Schaltung gemäß dem Oberbegriff des Patentanspruchs 56.

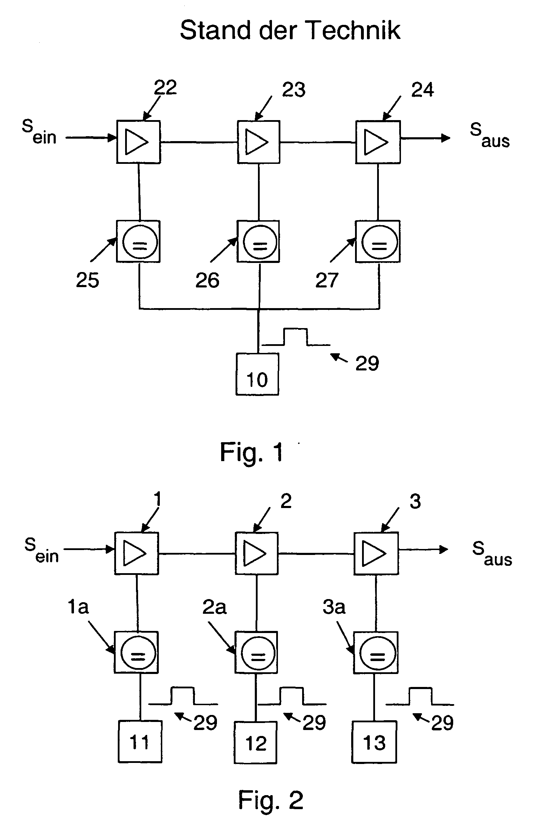

Aus DE 29 04 011 C3 ist ein Hochfrequenzverstärker bekannt, bestehend aus einer in Reihe geschalteten in Basisschaltung ausgeführten Leistungstransistor-Verstärkerstufen 22, 23, 24, welcher in Fig. 1 dargestellt ist. Dabei werden emitterseitig über ein Eingangsanpassungsnetzwerk eingegebene Hochfrequenzimpulse Sₑᵢₙ verstärkt und kollektorseitig über ein Ausgangsanpassungsnetzwerk Sₐᵤₛ abgegeben, wobei die Impulse eine vorgegebene Hüllenform aufweisen. In der bekannten Schaltung ist an jeder Verstärkerstufe 22, 23, 24 eine von einem Pulsgeber 10 gesteuerte Konstantstromquelle 25, 26, 27 angeschlossen, die der Kollektor-Emitterstrecke des jeweiligen Leistungstransistors 22, 23, 24 für die Dauer eines jeden vom Pulsgeber 10 abgegebenen Impulses 29 einen dem Impulsverlauf entsprechenden Strom einprägt.

Ein Nachteil dieser Schaltung ist, dass es beim gleichzeitigen Ein- bzw. Abschalten der Verstärkerstufen zu Wechselwirkungen zwischen den einzelnen Stufen kommen kann, da jeder Leistungstransistor ein unterschiedliches Einschwingverhalten aufzeigt. Diese Wechselwirkungen können dann zu unerwünschten Spektralanteilen führen.

Aus JP 60 127806 ist eine Schaltung mit einer Verstärkerkette bekannt mittels der eine Überlastsituation beim Ein- und Ausschalten der Bias-Spannung vermieden werden soll. Dazu werden die Bias-Spannungen individuell und mit Verzögerung ein- bzw. ausgeschaltet.

Die Druckschrift JP 02 166908 bezieht sich auf die Unterdrückung der Synchronisationszeit bei einem mehrstufigen injektionssynchronisierten Verstärker, dadurch dass die folgenden Verstärkerstufen immer erst dann eingeschaltet werden, wenn die jeweils vorhergehende zum Eingangssignal synchronisiert ist.

Die Aufgaben werden durch das Verfahren gemäß Patentanspruch 1 und durch die Schaltung gemäß Patentanspruch 6 gelöst. Vorteilhafte Ausführungen der Erfindung sind Gegenstand von Unteransprüchen.

Erfindungsgemäß werden die einzelnen Verstärkerstufen mit einem Ansteuersignal vorgebbarer Pulslänge angesteuert, wobei aufeinander folgende Verstärkerstufen jeweils nach einer vorgebbaren Verzögerungszeit Δt_{ein 1}, Δt_{ein 2} angesteuert werden. Während des Pulses, also wenn ein Ansteuersignal an der Verstärkerstufe anliegt, ist somit die Verstärkerstufe eingeschaltet und verstärkt das Eingangssignal.
Mit der Verwendung der zeitlichen Staffelung wird der Effekt von nichtlinearen Verzerrungen bei den Schaltvorgängen der Leistungsverstärkern vermieden, da zunächst jede Verstärkerstufe nacheinander einschwingen kann, bevor die nachfolgende aktiviert wird. Störungen im trägernahen Bereich des Ausgangssignalspektrums können somit minimiert werden.
Mit einem entsprechend zeitlich abgestimmten Ein- und Ausschalten der kaskadierten Verstärkerstufen wird eine Verbesserung des Signalspektrums im trägernahen Bereich bewirkt.

Bei einer erfindungsgemäßen Schaltung ist jeder Stromquelle jeweils ein Impulsgeber zugeordnet, welcher die Ansteuersignale an die der Stromquelle zugeordneten Verstärkerstufe erzeugt. Dadurch wird gewährleistet, dass die einzelnen Verstärkerstufen unabhängig voneinander mit einem Ansteuersignal versorgt werden.

Mit dem erfindungsgemäßen Verfahren und der erfindungsgemäßen Schaltung ist es möglich, ein Sendespektrum zu erzeugen, welches im trägernahen Bereich eine hohe spektrale Reinheit aufweist.

In einer vorteilhaften Ausführung des erfindungsgemäßen Verfahrens erfolgt die Ansteuerung der einzelnen Verstärkerstufen in einer zeitlichen Reihenfolge steigender Verstärkerausgangsleistung. Das bedeutet, dass Verstärkerstufen mit einer hohen Verstärkerausgangsleistung zeitlich nach Verstärkerstufen mit einer niedrigen Verstärkerausgangsleistung eingeschaltet werden, d.h. angesteuert werden. Diese Zeitverzögerung in der Ansteuerung aufeinander folgender Verstärkerstufen wird auch als Start-Delay bezeichnet.
Erfindungsgemäß ist die Verstärkerausgangsleistung der einzelnen Verstärkerstufen umgekehrt proportional zur Pulslänge des jeweiligen Ansteuersignals der Verstärkerstufe. Dies bedeutet, dass Verstärkerstufen mit niedriger Verstärkerausgangsleistung länger angesteuert werden und somit eingeschaltet sind als diejenigen Verstärkerstufen mit einer höherenVerstärkerausgangsleistung.

In einer vorteilhaften Ausführung der Erfindung werden die Verstärkerstufen in umgekehrter Reihenfolge ihres Einschaltens nach einer vorgebbaren Verzögerungszeit abgeschaltet. Diese Verzögerungszeit wird auch als Stop-Delay bezeichnet. Zweckmäßig können die Verstärkerstufen auch gleichzeitig abgeschaltet werden.

Die Erfindung wird im Folgenden anhand von Zeichnungen näher erläutert. Es zeigen:
- Fig. 1: einen Schaltungsaufbau einer mehrstufigen Verstärkeranordnung gemäß dem Stand der Technik,
- Fig. 2: einen beispielhaften erfindungsgemäßen Schaltungsaufbau einer dreistufigen Verstärkeranordnung,
- Fig. 3: eine beispielhafte Darstellung des erfindungsgemäßen zeitlichen Ablaufs der Ansteuersignale einer dreistufigen Verstärkeranordnung.

Fig. 2 zeigt einen beispielhaften erfindungsgemäßen Schaltungsaufbau einer dreistufigen Verstärkeranordnung. Die einzelnen Verstärkerstufen 1, 2, 3 sind in Reihe geschaltet, wobei die einzelnen Verstärkerstufen in der Reihenfolge steigender Verstärkerausgangsleistung verschaltet sind. Im vorliegenden Beispiel weist die Verstärkerstufe 1 somit die niedrigste und die Verstärkerstufe 3 die höchste Verstärkerausgangsleistung auf.
Die einzelnen Verstärkerstufen 1, 2, 3 umfassen typischerweise Bipolartransistoren (nicht dargestellt). Jede Verstärkerstufe 1, 2, 3 ist mit einer gepulsten Stromquelle 1a, 2a, 3a verbunden, wobei die Stromquellen 1a, 2a, 3a jeweils mit dem Emitter des jeweiligen Bipolartransistors verbunden sind.

Jede Stromquelle 1a, 2a, 3a ist außerdem jeweils mit einem Pulsgeber 11, 12, 13 verbunden. Dadurch wird gewährleistet, dass die Ansteuerung der einzelnen Verstärkerstufen 1, 2, 3 unabhängig voneinander erfolgt. Jeder Verstärkerstufe 1, 2, 3 ist somit eine eigene Stromquelle 1a, 2a, 3a zugeordnet, welcher wiederum jeweils ein eigener Pulsgeber 11, 12, 13 zugeordnet ist. Dadurch wird im Gesamten eine voneinander unabhängige Ansteuerung der einzelnen Verstärkerstufen 1, 2, 3 gewährleistet.

In der Schaltung ist vor der dreistufigen Verstärkeranordnung mit den Verstärkerstufen 1, 2, 3 zweckmäßig eine Vorverstärkerstufe angeordnet, welcher ein Eingangssignal Sₑᵢₙ zugeführt ist.

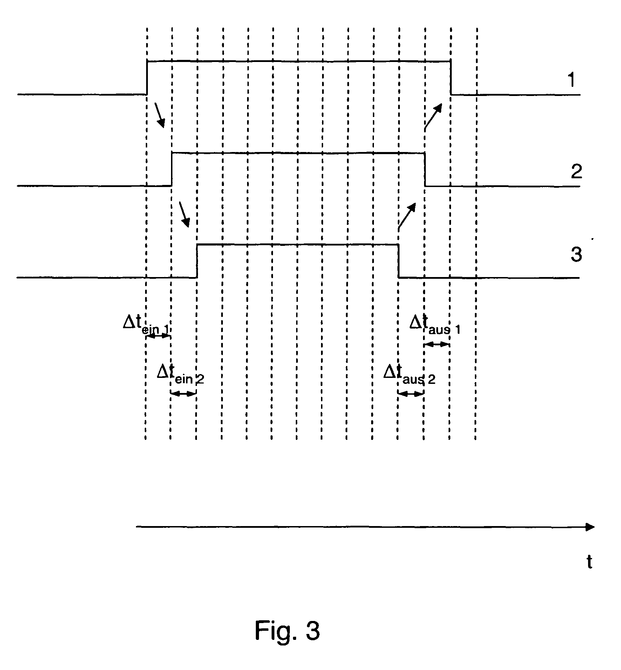

In Fig. 3 ist der zeitliche Ablauf der jeweiligen Ansteuersignale für die einzelnen Verstärkerstufen beispielhaft dargestellt. Die Darstellung zeigt, dass die Verstärkerstufe 1 zeitlich vor der Verstärkerstufe 2, welche wiederum zeitlich vor der Verstärkerstufe 3 angesteuert wird. Die jeweiligen Zeitabschnitte Δt_{ein 1}, Δt_{ein 2} des Start-Delays sind individuell einstellbar.
Aus der Darstellung ist deutlich zu erkennen, dass die einzelnen Verstärkerstufen 1, 2, 3 in umgekehrter Reihenfolge ihres Einschaltens wieder ausgeschaltet werden. Die dargestellten Stop-Delays Δt_{aus 1}, Δt_{aus 2} sind ebenso individuell einstellbar. Selbstverständlich können die Stop-Delays auch zu 0 sec. reduziert werden, was ein gleichzeitiges Ausschalten aller Verstärkerstufen 1, 2, 3 bedeutet.
Die Zeitabschnitte Δt_{ein 1}, Δt_{ein 2}, Δt_{aus 1}, Δt_{aus 2} müssen nicht gleich sein, sondern sind frei wählbar. Dabei werden die unterschiedlichen Start- und Stopdelays so ausgewählt, bis sich ein spektrales Optimum ergibt.
Aus der Darstellung wird deutlich, dass die einzelnen Verstärkerstufen 1, 2, 3 in der Reihenfolge steigender Verstärkerausgangsleistung eingeschaltet und in umgekehrter Reihenfolge ausgeschaltet werden.

## Patentansprüche

1. Verfahren zur Formung eines einer mehrstufigen Verstärkeranordnung zugeführten Eingangssignals Sₑᵢₙ in ein vorgebbares Ausgangssignalspektrums Sₐᵤₛ, wobei die einzelnen Verstärkerstufen (1, 2, 3) mit einem Ansteuersignal einer gepulsten Stromquelle (1a, 2a, 3a) vorgebbarer Pulslänge T angesteuert werden, **dadurch gekennzeichnet, dass**
aufeinander folgende Verstärkerstufen (1, 2, 3) jeweils nach einer vorgebbaren Verzögerungszeit Δt_{ein 1}, At_{ein 2} angesteuert werden, wobei die Verstärkerausgangsleistungen der Verstärkerstufen (1, 2, 3) umgekehrt proportional zur Pulslänge des Ansteuersignals sind.

2. Verfahren nach Anspruch 1, wobei die Ansteuerung der Verstärkerstufen (1, 2, 3) in einer zeitlichen Reihenfolge steigender Verstärkerausgangsleistung erfolgt.

3. Verfahren nach Anspruch 2, wobei die Verstärkerstufen (1, 2, 3) in umgekehrter Reihenfolge ihres Einschaltens nach einer vorgebbaren Verzögerungszeit Δtₐᵤₛ abgeschaltet werden.

4. Verfahren nach Anspruch 2, wobei die Verstärkerstufen (1, 2, 3) gleichzeitig abgeschaltet werden.

5. Schaltung zur Formung eines einer mehrstufigen Verstärkeranordnung zugeführten Eingangssignals Sₑᵢₙ in ein vorgebbares Ausgangssignalspektrums Sₐᵤₛ umfassend Verstärkerstufen (1, 2, 3) mit jeweils zugeordneten gepulsten Stromquellen (1a, 2a, 3a) zur Erzeugung von den jeweiligen Verstärkerstufen (1, 2, 3) zuführbaren Ansteuersignalen vorgebbarer Pulslänge T,
**dadurch kennzeichnet, dass**
jeder Stromquelle (1a, 2a, 3a) jeweils ein Impulsgeber (11, 12, 13) zugeordnet ist und die Verstärkerausgangsleistungen der Verstärkerstufen (1, 2, 3) umgekehrt proportional zur Pulslänge des Ansteuersignals sind.

## Claims

1. Method for formation of an input signal, Sᵢₙ, which is supplied to a multistage amplifier arrangement, to form a predeterminable output signal spectrum Sₒᵤₜ, with the individual amplifier stages (1, 2, 3) being driven using a drive signal from a pulsed current source (1a, 2a, 3a) of predeterminable pulse length T, **characterized in that**
successive amplifier stages (1, 2, 3) are each driven after a predeterminable delay time Δt_{on 1}, Δt_{on 2}, with the amplifier output powers of the amplifier stages (1, 2, 3) being inversely proportional to the pulse length of the drive signal.

2. Method according to Claim 1, with the drive for the amplifier stages (1, 2, 3) being produced in a time sequence of rising amplifier output power.

3. Method according to Claim 2, with the amplifier stages (1, 2, 3) being switched off in the opposite sequence to that in which they are switched on, after a predeterminable delay time Δt_{off}.

4. Method according to Claim 2, with the amplifier stages (1, 2, 3) being switched off at the same time.

5. Circuit for formation of an input signal, Sᵢₙ, which is supplied to a multistage amplifier arrangement, to form a predeterminable output signal spectrum Sₒᵤₜ, comprising amplifier stages (1, 2, 3) with respectively associated pulsed current sources (1a, 2a, 3a) for production of drive signals which can be supplied to the respective amplifier stages (1, 2, 3) and have a predeterminable pulse length T,
**characterized in that**
each current source (1a, 2a, 3a) has a respectively associated pulse transmitter (11, 12, 13), and the amplifier output powers of the amplifier stages (1, 2, 3) are inversely proportional to the pulse length of the drive signal.

## Revendications

1. Procédé de formation d'un signal d'entrée S_{entrée} délivré à une disposition d'amplificateur à multi-étages dans un spectre de signaux de sortie prédéterminable Sₛₒᵣₜᵢₑ, les différents étages d'amplification (1, 2, 3) étant activés avec un signal d'activation d'une source de courant impulsionnelle (1a, 2a, 3a) d'une longueur d'impulsion T prédéterminable, **caractérisé en ce que** les étages d'amplification (1, 2, 3) successifs sont chacun activés après une temporisation prédéterminable Δt_{entrée 1}, Δt_{entrée 2}, les puissances de sortie d'amplificateur aux étages d'amplification (1,2,3) étant inversement proportionnelles à la longueur d'impulsion du signal d'activation.

2. Procédé selon la revendication 1, dans lequel l'activation des étages d'amplification (1, 2, 3) s'effectue dans un ordre temporel de puissance croissante de sortie d'amplificateur.

3. Procédé selon la revendication 2, dans lequel les étages d'amplification (1, 2, 3) sont déclenchés dans un ordre inverse de celui de leur enclenchement après une temporisation prédéterminable Δtₛₒᵣₜᵢₑ.

4. Procédé selon la revendication 2, dans lequel les étages d'amplification (1, 2, 3) sont déclenchés simultanément.

5. Circuit destiné à la formation d'un signal d'entrée S_{entrée} délivré à une disposition d'amplificateur à multi-étages dans un spectre de signaux de sortie prédéterminable Sₛₒᵣₜᵢₑ comprenant des étages d'amplification (1, 2, 3) chacun pourvus d'une source de courant impulsionnelle (1a, 2a, 3a) pour générer des signaux d'activation pouvant être délivrés aux étages d'amplification respectifs (1, 2, 3) et présentant une longueur d'impulsion prédéterminable T, **caractérisé en ce qu'**un émetteur d'impulsions (11, 12, 13) est à chaque fois associé à chaque source de courant (1a, 2a, 3a) et que les puissances de sortie d'amplificateur sont inversement proportionnelles à la longueur d'impulsion du signal d'activation.
